## Europäisches Patentamt

## European Patent Office

## Office européen des brevets

(11) Numéro de publication: **0 226 498**
**B1**

(12) **FASCICULE DE BREVET EUROPEEN**

(45) Date de publication du fascicule du brevet:
**05.09.90**

(21) Numéro de dépôt: **86402567.1**

(22) Date de dépôt: **19.11.86**

(51) Int. Cl.⁵: **H01L 23/48**

(54) Organe lamellaire de liaison électrique de deux circuits.

(30) Priorité: **11.12.85 FR 8518310**

(43) Date de publication de la demande:
**24.06.87 Bulletin 87/26**

(45) Mention de la délivrance du brevet:
**05.09.90 Bulletin 90/36**

(84) Etats contractants désignés:
**DE ES GB IT**

(56) Documents cités:
**EP-A- 0 077 276**
**EP-A- 0 157 685**

(73) Titulaire: **VALEO EQUIPEMENTS ELECTRIQUES MOTEUR, 2, Rue André Boulle, F-94000 Creteil(FR)**

(72) Inventeur: **Heritier-Best, Pierre, Orbeil, F-63500 Issoire(FR)**

(74) Mandataire: **Gamonal, Didier, Société VALEO Service Propriété Industrielle 30, rue Blanqui, F-93406 Saint Ouen(FR)**

ACTORUM AG

## Description

L'invention concerne un organe de liaison électrique du type constitué par un réseau de conducteurs lamellaires dont l'une de leurs extrémités sont destinées à être raccordées par soudure à un circuit électronique tandis que les autres extrémités constituent avantageusement les fiches d'au moins un connecteur électrique obtenu de moulage avec un boîtier dans lequel est logé le circuit électronique.

Il est connu d'obtenir un tel organe de liaison par découpage d'un réseau de conducteurs laméllaires, dont l'une des extrémités constitue des fiches débouchant dans un logement du boîtier surmoulé pour constituer un connecteur et l'autre des extrémités destinées à être soudées sont initialement reliées entre elles par un pont obtenu au cours de l'opération de découpe et ayant pour rôle de maintenir entre elles et en position lesdites lamelles pendant l'opération de surmoulage.

De tels réseaux doivent avoir de bonnes caractéristiques mécaniques et de résistances à l'oxydation pour ce qui est de la partie connecteur, mais doivent également présenter des caractéristiques de soudabilité compatibles notamment avec la soudure aux ultra-sons.

Pour atteindre ce double objectif et donc obtenir un matériau alliant ces différentes caractéristiques, ces organes de liaison sont obtenus de manière connue par l'utilisation d'un bronze nickelé doré, le bronze pour ces qualités de tenue mécanique, le nickel pour sa compatiblité avec la soudure aux ultra-sons, la dorure pour sa résistance à l'oxydation.

Ces traitements ont plusieurs inconvénients, ils sont extrêmement onéreux et de plus ne sont pas parfaits, car lors de l'opération de surmoulage du boîtier, il se dégage du matériau moulé un agent polluant, tel que stéréate de zinc, qui se dépose sur les extrémités des lamelles à souder et compromet l'efficacité de la soudure aux ultra-sons avec le circuit électronique.

L'efficacité de la soudure aux ultra-sons avec le circuit électronique est aussi perturbé par le cheminement des ondes ultra-sons qui sont dispersées hors de la zone de soudure, cela étant dû au bronze qui est un matériau trop rigide et qui provoque une résonance.

On pourrait penser de manière évidente à remplacer le bronze nickelé doré par de l'aluminium, car insensible au stéréate de zinc, mais un tel matériau ne conviendrait pas au niveau du connecteur car il a une mauvaise tenue mécanique.

La demande de brevet européen EP 0 157 685 décrit un réseau de conducteurs constitué de deux parties distinctes de deux matières différentes raccordées entre elles par soudure. Mais dans ce brevet c'est la partie extérieure qui est réalisée en aluminium et non celle raccordée au circuit à l'intérieur du boîtier. Le problème du stéréate de zinc n'est donc pas résolu, pas plus que la tenue mécanique du connecteur.

La présente invention a pour but de pallier ces inconvénients et propose à cet effet un organe de liaison du type constitué par un réseau de conducteurs lamellaires dont l'une de leurs extrémités sont destinées à être raccordées par soudure à un circuit électronique tandis que leurs autres extrémités constituent avantageusement les fiches d'au moins un connecteur électrique obtenu de moulage avec un boîtier dans lequel est logé le circuit électronique, réseau de conducteurs préalablement constitué de deux parties distinctes complémentaires de deux matières différentes raccordées entre elles par soudure électrique, caractérisé en ce que la partie de l'organe est composée en aluminium, dont le raccordement des extrémités des conducteurs lamellaires au circuit électronique logé dans le boîtier, s'effectue par soudure aux ultra-sons, et la partie de l'organe destinée à constituer les fiches du connecteur est composée en bronze étamé.

La description qui va suivre en regard des dessins annexés fera mieux comprendre l'invention.

- La figure 1 représente les parties constitutives de l'organe de liaison selon l'invention.
- La figure 2 représente l'organe de liaison après raccordement de ces parties constitutives.
- La figure 3 représente l'organe de liaison avant insertion dans le boîtier.
- La figure 4 représente l'organe de liaison immédiatement après surmoulage du boîtier.
- La figure 5 représente l'organe de liaison dans le boîtier avant soudure du circuit électronique.

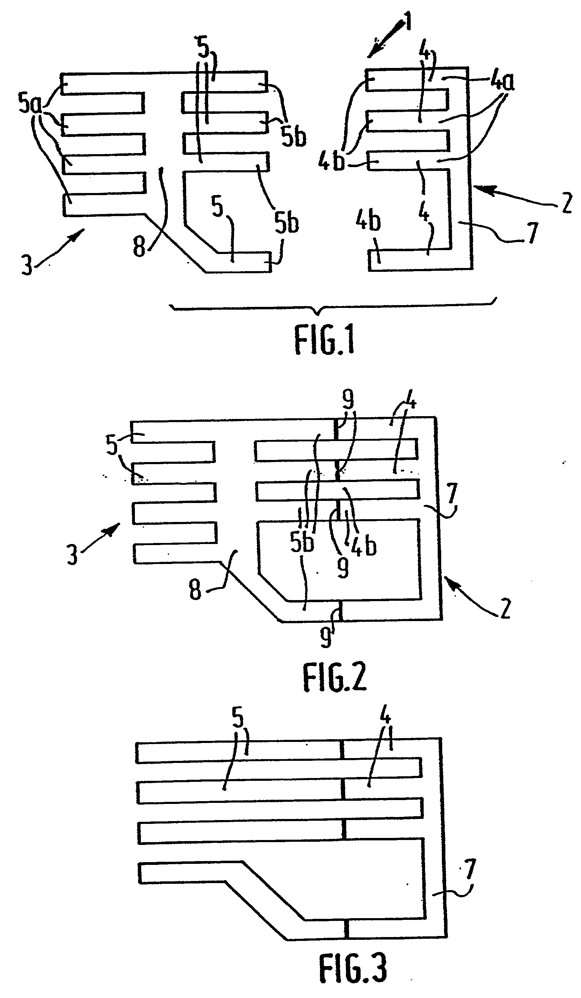

Selon la figure 1, l'organe de liaison électrique 1 est constitué de deux parties 2 et 3 définissant un réseau de conducteurs lamellaires 4 et 5 dont l'une de leurs extrémités 4a sont destinées à être raccordées par soudure aux ultra-sons à un circuit électronique 10 tandis que les autres extrémités 5a de la partie 3 constituent avantageusement les fiches d'un connecteur électrique 11 obtenu de moulage avec un boîtier 6 dans lequel est logé le circuit électronique 10.

Les deux parties 2 et 3 constituant le réseau laméllaire 4 et 5 sont distinctes, complémentaires, constituées de deux matières différentes et raccordées entre elles par des points de soudure électrique 9.

Les deux parties 2 et 3 possèdent respectivement des caractéristiques propres de soudabilité aux ultra-sons d'une part et de tenue mécanique d'autre part.

Pour atteindre ce résultat, la partie 2 est obtenue par découpage d'un flanc en aluminium de manière à obtenir les conducteurs lamellaires 4 du réseau et dont les extrémités 4a destinées à être raccordées ultérieurement au circuit électronique 10 sont reliées entre elles de matière par un pont commun 7, les extrémités 4b étant libres pour permettre ultérieurement la soudure électrique par points 9 avec les extrémités libres 5b de la partie 3.

La partie 3 est obtenue par découpage d'un flanc en bronze étamé de manière à obtenir les conducteurs lamellaires 5 du réseau et dont les extrémités 5a sont destinées à constituer les fiches du connecteur 11, et les extrémités libres 5b destinées à être soudées électriquement aux extrémités libres correspondantes 4b des conducteurs laméllaires 4.

Ces conducteurs laméllaires 5 sont reliés provisoirement les uns aux autres par un pont commun 8 obtenu de matière et permettant ainsi la rigidité et la cohésion de la partie 3 de manière à faciliter la soudure électrique par points 9 entre les extrémités 5b et 4b.

Les deux parties complémentaires 2 et 3 ainsi obtenues sont placées de tel sorte que les extrémités 4b et 5b soient disposées en vis-à-vis pour permettre d'effectuer la soudure électrique par points 9 (figure 2).

Le matériau constituant les parties 2 et 3 ainsi définies, c'est-à-dire bronze étamé et aluminium, permettent d'effectuer leur raccordement par soudure électrique dans des conditions normales, mais il peut être envisagé de parfaire ces conditions par l'utilisation, pour la partie 2, d'un lamifié aluminium-cuivre.

Les conducteurs laméllaires 5 étant ainsi solidairés par soudure électrique aux conducteurs laméllaires 4, le pont 8 peut être découpé entre chaque conducteurs laméllaires 5 (figure 3).

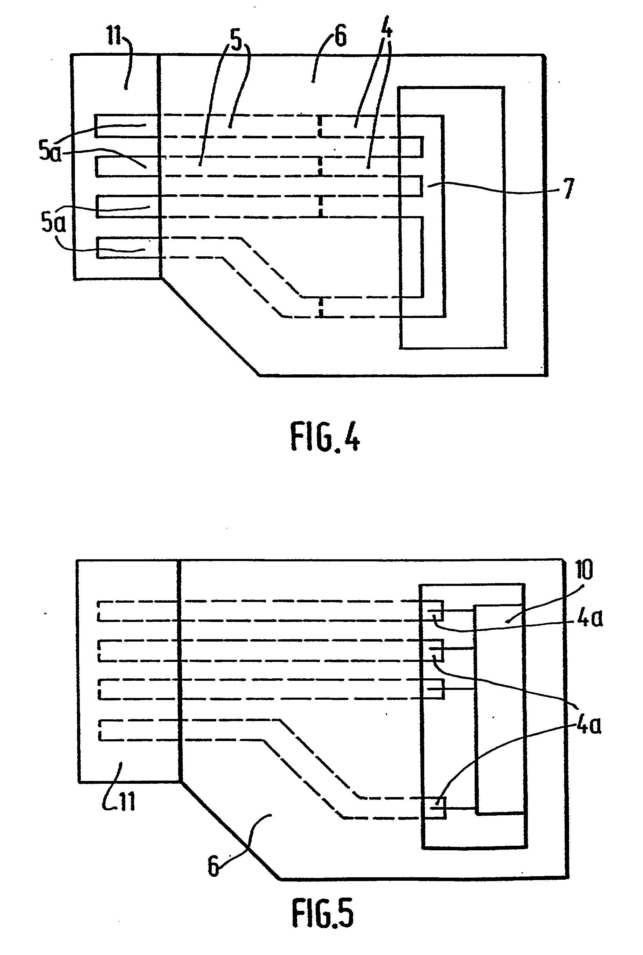

Le réseau de conducteurs laméllaires 4,5 ainsi constitué est inséré dans un moule de manière à obtenir par surmoulage un boîtier 6 prolongé par un connecteur 11 (figure 4).

Le pont 7 qui relie les extrémités 4a des conducteurs laméllaires 4 destinés à être raccordées par soudure aux ultra-sons au circuit électronique 10 est alors coupé entre chaque conducteurs laméllaires 4.

Les extrémités 4a ainsi libérées peuvent sans difficulté être soudées par ultra-sons au circuit électronique 10 inséré dans le boîtier 6.

## Revendications

1. Organe de liaison électrique (1) du type constitué par un réseau de conducteurs lamellaires (4, 5) dont l'une de leurs extrémités (4a) sont destinées à être raccordées par soudure à un circuit électronique (10) tandis que leurs autres extrémités (5a) constituent les fiches d'au moins un connecteur électrique (11) obtenu de moulage avec un boîtier (6) dans lequel est logé le circuit électronique (10), réseau de conducteurs (4, 5) préalablement constitué de deux parties (2, 3) distinctes complémentaires de deux matières différentes raccordées entre elles par soudure électrique (9), caractérisé en ce que la partie (2) de l'organe (1) est composé en aluminium, dont le raccordement des extrémités (4a) des conducteurs lamellaires (4) au circuit électronique (10) logé dans le boîtier (6), s'effectue par soudure aux ultra-sons, et la partie (3) de l'organe (1) destinée à constituer les fiches du connecteur (11) est composée en bronze étamé.

2. Organe de liaison électrique (1) selon la revendication 1, caractérisé en ce que chacune de ces parties complémentaires (2, 3) est obtenue par découpe de manière telle que les conducteurs lamellaires (4, 5) qui la composent sont reliés de matière les uns aux autres par un pont commun (7, 8).

3. Organe de liaison électrique (1) selon la revendication 1, caractérisé en ce que la partie (2) de l'organe (1) destinée à être raccordée par soudure au circuit électronique (10) est composée en un lamifié d'aluminium et de cuivre.

4. Organe de liaison électrique (1) selon l'une quelconque des revendications 2 et 3, caractérisé en ce que le pont (8) de la partie (3) destinée à constituer les fiches du connecteur électrique (11) est coupé entre chaque conducteurs lamellaires (5) qui la compose une fois le réseau constitué.

5. Organe de liaison électrique (1) selon l'une quelconque des revendications 1 et 4, caractérisé en ce que le réseau de conducteurs (2, 3) est inséré dans le boîtier (6) par surmoulage.

## Claims

1. An electrical connecting member (1) of the kind comprising a network of lamellar conductors (4, 5), one of the ends (4a) of each of which is adapted to be joined by welding to an electronic circuit (10), while their other ends (5a) constitute the pins of at least one electrical connector (11) which is obtained by moulding with a housing (6) in which the electronic circuit (10) is mounted, the network of conductors (4, 5) being constituted beforehand by two separate complementary component parts (2, 3) made of two different materials and joined to each other by electric welding (9), characterised in that the component part (2) of the member (1) is made of aluminium, the junction of the ends (4a) of its lamellar conductors (4) to the electronic circuit (10) mounted in the housing (6) being effected by ultrasonic welding, and the component part (3) of the member (1) which is arranged to constitute the pins of the connector (11) is made of tinned bronze.

2. An electrical connecting member (1) according to Claim 1, characterised in that each of the said complementary component parts (2, 3) is obtained by pressing in such a way that the lamellar conductors (4, 5) which constitute it are integrally connected with each other through a common bridge portion (7, 8).

3. An electrical connecting member (1) according to Claim 1, characterised in that the component part (2) of the member (1) which is adapted to be connected by welding to the electronic circuit (10) is made of a laminate of aluminium and copper.

4. An electrical connecting member (1) according to either one of Claims 2 and 3, characterised in that the bridge portion (8) of the component part (3) which is adapted to constitute the pins of the electrical connector (11) is cut between each of its lamellar conductors (5) and the next, once the network has been established.

5. An electrical connecting member (1) according to either one of Claims 1 and 4, characterised in that the network of conductors (2, 3) is inserted into the housing (6) by moulding.

## Patentansprüche

1. Elektrisches Verbindungsorgan (1) von der Art, die aus einem Netz lamellenförmiger Leiter (4, 5) besteht, deren eine Enden (4a) jeweils zum Anschweißen an eine elektronische Schaltung (10) bestimmt sind, während die jeweils anderen Enden (5a) die Stöpsel wenigstens eines elektrischen Steckers (11) bilden, der aus einem Stück mit einem Gehäuse (6) gefertigt ist, worin sich die elektronische Schaltung (10) befindet, und wobei das Leiternetz (4, 5) vorher aus zwei verschiedenen, einander ergänzenden Teilen (2, 3) aus zwei verschiedenen Werkstoffen gebildet wurde, die miteinander durch elektrische Schweißung (9) verbunden sind, dadurch gekennzeichnet, daß der Teil (2) des Organs (1) aus Aluminium besteht und die Enden (4a) der lamellenförmigen Leiter (4) mit der im Gehäuse (6) angeordneten elektronischen Schaltung (10) durch Ultraschallschweißung verbunden werden und der Teil (3) des Organs (1), woraus die Stöpsel des Steckers (11) gebildet werden, aus verzinnter Bronze besteht.

2. Elektrisches Verbindungsorgan (1) nach Anspruch 1, dadurch gekennzeichnet, daß jeder der einander ergänzenden Teile (2, 3) so ausgeschnitten wird, daß die lamellenförmigen Leiter (4, 5), woraus der betreffende Teil besteht, an einem gemeinsamen Punkt (7, 8) miteinander fest verbunden sind.

3. Elektrisches Verbindungsorgan (1) nach Anspruch 1, dadurch gekennzeichnet, daß der Teil (2) des Organs (1), der an die elektronische Schaltung (10) angeschweißt werden soll, aus einem Schichtstoff aus Aluminium und Kupfer besteht.

4. Elektrisches Verbindungsorgan (1) nach einem der Ansprüche 2 und 3, dadurch gekennzeichnet, daß die Brücke (8) des Teils (3), der die Stöpsel des elektrischen Steckers (11) bilden soll, nach Zustandekommen des Netzes zwischen den einzelnen lamellenförmigen Leitern (5), woraus sie besteht, unterbrochen wird.

5. Elektrisches Verbindungsorgan (1) nach einem der Ansprüche 1 und 4, dadurch gekennzeichnet, daß das Leiternetz (2, 3) durch Überformung in das Gehäuse (6) eingesetzt wird.

EP 0 226 498 B1

FIG.1

FIG.2

FIG.3

FIG.4

FIG.5